# EUROPÄISCHE PATENTSCHRIFT

(11) **EP 1 155 461 B1**
(45) Veröffentlichungstag und Bekanntmachung des Hinweises auf die Patenterteilung: **01.12.2004**
(21) Anmeldenummer: 00908946.7
(22) Anmeldetag: 27.01.2000
(51) Int. Cl.: H01L 39/12

(54) **HOCHTEMPERATURSUPRALEITERAUFBAU AUF METALLISCHEM TRÄGER MIT MEHRLAGIGER ZWISCHENSCHICHT**
HIGH Tc SUPERCONDUCTOR STRUCTURE PLACED ON A METALLIC SUBSTRATE AND COMPRISING AN INTERMEDIATE LAYER CONSISTING OF MULTIPLE LAYERS
STRUCTURE SUPRACONDUCTRICE HAUTE TEMPERATURE SUR SUPPORT METALLIQUE AVEC COUCHE INTERMEDIAIRE STRATIFIEE

(30) Priorität: 01.02.1999 DE 19903871
(43) Veröffentlichungstag der Anmeldung: 21.11.2001
(73) Patentinhaber: SIEMENS AKTIENGESELLSCHAFT, 80333 München (DE)
(72) Erfinder: SIPOS, Gisela, D-91056 Erlangen (DE); UTZ, Bernd, D-91052 Erlangen (DE); SCHMIDT, Wolfgang, D-91056 Erlangen (DE)
(86) Internationale Anmeldenummer: PCT/DE2000/000238
(87) Internationale Veröffentlichungsnummer: WO 2000/046863

(56) Entgegenhaltungen:
- WO-A-96/33069
- ICHINOSE A ET AL: "Deposition of Y2O3 buffer layers on biaxially-textured metal substrates" PHYSICA C, NORTH-HOLLAND PUBLISHING, NL, Bd. 302, Nr. 1, 1998, Seiten 51-56, XP004149099 ISSN: 0921-4534
- IGNATIEV A ET AL: "Photo-assisted MOCVD growth of YBCO thick films for wire applications" APPLIED SUPERCONDUCTIVITY, ELSEVIER, UK, Bd. 4, Nr. 10-11, 1996, Seiten 455-463, XP004108063 ISSN: 0964-1807

## Beschreibung

Die Erfindung bezieht sich auf einen langgestreckten Supraleiteraufbau zur Führung eines elektrischen Stromes in einer vorbestimmten Richtung. Dieser Aufbau soll folgende Teile aufweisen, nämlich einen biaxial texturierten Träger aus metallischem Material, ein auf dem Träger abgeschiedenes Zwischenschichtsystem mit mindestens zwei Zwischenschichten aus verschiedenen oxidischen Materialien und eine auf dem Zwischenschichtsystem abgeschiedene Supraleitungsschicht aus einem Hoch-T_{c}-Supraleitermaterial vom Typ (RE)M₂Cu₃Oₓ, wobei die Komponente RE wenigstens ein Seltenes Erdmetall (einschließlich Yttrium) und die Komponente M wenigstens ein Erdalkalimetall enthalten. Die Erfindung betrifft ferner ein Verfahren zur Herstellung eines solchen Supraleiteraufbaus. Ein entsprechender Supraleiteraufbau und ein Verfahren zu dessen Herstellung sind beispielsweise aus WO 96 33069 A und aus *"Applied Superconductivity*", *1996, Vol. 4, Nos. 10-11, Seiten 403 bis 427* zu entnehmen.

Es sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und insbesondere eine Flüssig-Stickstoff (LN₂)-Kühltechnik erlauben. Unter solche Metalloxidverbindungen fallen insbesondere Cuprate auf Basis spezieller Stoffsysteme wie das vom Typ (RE)-M-Cu-O, wobei die Komponenten RE wenigstens ein Seltenes Erdmetall (einschließlich Y) und die Komponente M wenigstens ein Erdalkalimetall enthalten. Hauptvertreter dieses Typs ist das Material YBa₂Cu₃Oₓ (sogenanntes "YBCO").

Diese bekannten HTS-Materialien versucht man, auf verschiedenen Trägern (Substraten) für unterschiedliche Anwendungszwecke abzuscheiden, wobei im allgemeinen im Hinblick auf eine hohe Stromtragfähigkeit nach möglichst phasenreinem, texturiertem Supraleitermaterial getrachtet wird. Unter eine= Texturierung sei hierbei die Ausrichtung der Kristallite eines polykristallinen Gefüges verstanden. Insbesondere werden langgestreckte metallische Träger für Leiteranwendungen vorgesehen (vgl. z.B. *EP 0 292 959 A2)*.

Bei einem entsprechenden Supraleiteraufbau für Leiteranwendungen wird das HTS-Material im allgemeinen nicht unmittelbar auf einem als Substrat dienenden metallischen Trägerband abgeschieden; sondern dieses Trägerband wird zunächst mit mindestens einer dünnen Zwischenschicht, die auch als Pufferschicht ("Buffer"-Schicht) bezeichnet wird, abgedeckt. Diese Zwischenschicht mit einer Dicke in der Größenordnung von etwa 1 µm soll das Eindiffundieren von Metallatomen aus dem Trägermaterial in das HTS-Material verhindern, um eine damit verbundene Verschlechterung der supraleitenden Eigenschaften zu vermeiden. Zugleich kann mit einer solchen als Diffusionsbarriere dienenden Zwischenschicht die Oberfläche geglättet und die Haftung des HTS-Materials verbessert werden. Entsprechende Zwischenschichten bestehen insbesondere aus Oxiden von Metallen wie von Zirkon, Cer, Yttrium, Aluminium, Strontium oder Magnesium oder von Legierungen mit diesen Metallen und sind somit in der Regel elektrisch isolierend.

Neben der Eigenschaft als Diffusionsbarriere soll diese mindestens eine Zwischenschicht darüber hinaus die Forderung erfüllen, daß sie ein texturiertes Wachstum des auf ihr aufzubringenden HTS-Materials ermöglicht. Folglich muß die Zwischenschicht selbst eine entsprechende Textur besitzen. Der Übertrag der kristallographischen Orientierung beim Wachstum einer Schicht auf einer chemisch andersartigen Unterlage ist unter dem Begriff "Heteroepitaxie" bekannt. Dabei muß die Zwischenschicht an die Gitterkonstanten des HTS-Materials möglichst gut angepaßte Abmessungen seiner Einheitszellen besitzen. Darüber hinaus sollte es einen thermischen Ausdehnungskoeffizienten aufweisen, der mit dem des HTS-Materials zumindest annähernd übereinstimmt, um so unerwünschte mechanische Spannungen bei den für Anwendungen der Supraleitungstechnik und der Schichtpräparation unerläßlichen Temperaturzyklen und gegebenenfalls dadurch bedingt Schädigungen wie Abplatzen zu vermeiden.

Ähnliche Anforderungen sind auch an die Auswahl des Systems "Träger-Zwischenschicht" zu stellen. Auch hier sind gute Hafteigenschaften anzustreben, wobei zugleich die gewünschte Heteroepitaxie zwischen der Zwischenschicht und der darauf aufwachsenden HTS-Schicht nicht beeinträchtigt werden darf.

Aus den vorerwähnten Gründen ist gemäß der eingangs genannten Literaturstelle ein durch einen Walzprozeß an seiner Oberfläche biaxial texturiertes Metallband aus Cu oder Ni als Trägerband vorgesehen, auf dem eine Zwischenschicht in Form einer CeO₂-Schicht (als erste Pufferschicht) und eine dickere Schicht aus mit Y stabilisiertem ZrO₂ (Zr(Y)O₂ als zweite Pufferschicht) abgeschieden sind. Diese Kombination wurde gewählt, weil sich CeO₂ zur Vermeidung der Oxidation der Metalloberfläche in reduzierender Atmosphäre heteroepitaktisch auf texturiertem Ni abscheiden läßt. Durch ein dabei im CeO₂ entstehendes Sauerstoffdefizit und die damit verbundene Vergrößerung der Gitterkonstanten neigt jedoch die Schicht zur Bildung von Rissen. Es werden deshalb maximal nur 100 nm dicke CeO₂-Schichten verwendet, um die Flächendichte an entsprechenden Rissen einzuschränken. Dickere CeO₂-Schichten neigen nämlich leichter zu Rissen als dünne Schichten. Dies macht eine zweite Lage aus dem Zr(Y)O₂ erforderlich, um eventuelle Risse oder sonstige mechanische Schäden überdecken zu können. Diese zweite Schicht muß so dick gemacht werden, beispielsweise bis zu 1 µm, daß sie die eigentliche Diffusionssperre darstellt. Ein entsprechendes Zwischenschichtsystem ist unter anderem in der *US 5,739,086 A* oder der *US 5,741,377 A* beschrieben.

An einen solchen Leiteraufbau ist also die Forderung nach einer Abscheidung von rißfreien und gegen Diffusion dichten Zwischenschichten auf Metallbändern zu stellen. Im Hinblick auf eine für hohe kritische Stromdichten J wichtige Heteroepitaxie ist zudem von einem biaxial texturierten Metallband auszugehen, um so die Textur des Bandes in das supraleitende Material übertragen zu können. Damit sollen mit supraleitendem YBCO-Material oder einem entsprechenden HTS-Material beschichtete bandförmige Leiter großer Länge herzustellen sein.

Für bisher konzipierte Anwendungen einer verlustfreien Übertragung hoher Ströme z.B. in Form von gewickelten Bändern in Magnetspulen oder Trafos, die dann hohen Magnetfeldern ausgesetzt sind, werden hohe kritische Stromdichten J_{c} in der YBCO-Schicht von mindestens 1 x 10⁵ A/cm² bei einer Schichtdicke des YBCO-Materials von beispielsweise 0,8 µm benötigt. Dies könnte nur dann erzielt werden, wenn die Kristallite der YBCO-Schicht in der kristallinen a-b-Ebene einheitlich ausgerichtet sind, da dann bekanntlich Kleinwinkelkorngrenzen eine hohe Stromtragfähigkeit zur Folge haben. Man spricht hier auch von einer biaxialen Textur. Daraus folgt die Notwendigkeit, daß die bereits im Träger vorhandene biaxiale Textur durch die Zwischenschichten auf das YBCO übertragen werden muß. Als Maß für die Güte der biaxialen Textur dient die sogenannte Halbwertsbreite (FWHM) im sogenannten röntgenographischen "Phi-Scan"; diese sollte für das Zwischenschichtsystem 10° nicht wesentlich überschreiten. Entsprechende Untersuchungen sind in "Journal of Materials Research", Vol. 7, No. 7, July 1992, Seiten 1641 bis 1651, insbesondere Seiten 1644 und 1645 angesprochen.

Aufgabe der vorliegenden Erfindung ist es, ein Zwischenschichtsystem anzugeben, welches die genannten Forderungen erfüllt, so daß auch längere Trägerstücke, insbesondere von mehr als 1 m, vorzugsweise über 100 m, mit gleichbleibender Qualität beschichtet werden können. Dabei soll eine Diffusion von Metallatomen aus dem Trägermaterial in die YBCO-Schicht ebenso wie die Diffusion von_Sauerstoff, der bei der Abscheidung und Ausbildung des YBCO erforderlich ist, zur Metalloberfläche verhindert werden. Eine derartige Sauerstoffdiffusion würde nämlich bei den üblichen Abscheide- und Glühtemperaturen des YBCO-Materials im Bereich von etwa 600 bis 800°C zu einer Metall-Oxidation führen und damit die Haftfestigkeit der Zwischenschicht herabsetzen. Aus diesem Grunde sind im allgemeinen Dicken des Zwischenschichtsystems zwischen etwa 0,5 und 2 µm erforderlich, wobei diese Dicken vom gewählten Zwischenschichtmaterial abhängig sind.

Diese Aufgabe wird für einen Supraleiteraufbau mit den eingangs genannten Merkmalen erfindungsgemäß dadurch gelöst, daß das Zwischenschichtsystem eine dem Träger zugewandte Zwischenschicht aus einem Yttrium-Oxid und eine dem Supraleitermaterial zugewandte, vergleichsweise dünnere Zwischenschicht aus einem Cer-Oxid aufweist. Hauptvertreter dieser Oxide sind Y₂O₃ bzw. CeO₂. Geringe Verunreinigungen oder Beimengungen, insbesondere von anderen Metalloxiden, bis zu einem Anteil von 5 Gew.-% sollen jedoch jeweils mit eingeschlossen sein.

Die mit dieser Ausgestaltung des Zwischenschichtsystems verbundenen Vorteile sind insbesondere in Folgendem zu sehen:
- Die dem Träger zugewandte (erste) Zwischenschicht kann heteroepitaktisch auf dem metallischen Träger aufwachsen; dies ist zu gewährleisten, wenn eine Oxidbildung auf der Metalloberfläche verhindert wird. Hierzu muß sich das Metalloxid der ersten Zwischenschicht in reduzierender bzw. sauerstoffarmer Atmosphäre abscheiden lassen und eine deutlich höhere Bindungsenergie als das Metalloxid des Trägermaterials haben. Diese Forderungen sind mit dem gewählten Y₂O₃ zu erfüllen.
- Die dem Supraleitermaterial zugewandte (zweite) Zwischenschicht besitzt eine an das gewählte Supraleitermaterial sehr gut angepaßte Gitterkonstante. Der entsprechende Fehler (sogenannter "lattice miss match") liegt nämlich im Falle des zu verwendenden CeO₂ unter 1,6 %, während der von Y-stabilisiertem ZrO₂ 5,5 % beträgt.
- Das gesamte Zwischenschichtsystem verhindert chemische Reaktionen zwischen dem Metall des Trägermaterials und dem Supraleitermaterial während der erforderlichen Beschichtungsprozesse des Trägers. Es weist nämlich eine geringe Diffusionsrate für die beteiligten Elemente auf. Darüber hinaus läßt es sich auch über große Längen reproduzierbar ausbilden, wobei keine "makroskopischen" Defekte wie z.B. Risse auftreten. Die gewählte Kombination der Zwischenschichtmaterialien ist folglich besonders geeignet zur Herstellung eines langgestreckten Leiteraufbaus großer Länge unter Verwendung der genannten Materialien für dessen Träger und dessen Supraleiter.

Vorteilhafte Ausgestaltungen des erfindungsgemäßen Supraleiteraufbaus gehen aus den diesbezüglich abhängigen Ansprüchen hervor.

Dabei wird vorteilhaft ein Träger aus Nickel oder einer Nickel-Legierung gewählt. Träger aus solchen Materialien besitzen nämlich zum einen thermische Ausdehnungskoeffizienten, die in der Größenordnung von Y₂O₃ liegen. Zum anderen kann man an der zu beschichtenden Oberfläche dieser Träger in an sich bekannter Weise (vgl. die eingangs genannte Literaturstelle) und verhältnismäßig einfach die erforderliche biaxiale Textur erzeugen.

Dementsprechend wird vorzugsweise der Träger an seiner dem Zwischenschichtsystem zugewandten Oberfläche mit einer Walztextur versehen.

Vorzugsweise ist das Supraleitermaterial vom Typ YBa₂Cu₃Oₓ (YBCO).

Ebensogut kann ein Material verwendet werden, bei dem, ausgehend von YBCO, die Komponente Y und/oder die Komponente Ba zumindest teilweise durch ein Element aus der jeweils entsprechenden Gruppe ersetzt sind/ist.

Vorteilhaft hat die CeO₂-Zwischenschicht eine Dicke von unter 200 nm, vorzugsweise 100 nm, und von mindestens 10 nm. Bei dieser Schichtdicke ist eine gute Heteroepitaxie zu gewährleisten. Außerdem wird das Entstehen von Rissen verhindert.

Ferner ist es als vorteilhaft anzusehen, wenn die Y₂O₃-Zwischenschicht eine Dicke zwischen 200 nm und 2 µm hat. Eine derartige, verhältnismäßig dicke Zwischenschicht gewährleistet die Dichtheit des gesamten Zwischenschichtsystems auch über große Längen des Supraleiteraufbaus.

Besonders vorteilhaft ist es, wenn zur Herstellung des Supraleiteraufbaus ein zumindest weitgehend heteroepitaktisches Wachstum der Zwischenschichten und der Supraleitungsschicht gewährleistet wird. Die Halbwertsbreite (FWHM) im röntgenographischen Phi-Scan sollte dabei unter 20°, vorzugsweise unter 15° liegen. Denn damit ist eine hohe kritische Stromdichte J_{c} der Supraleitungsschicht zu erreichen.

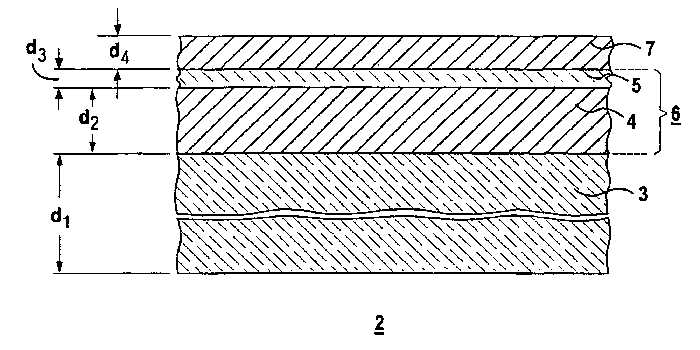

Zur weiteren Erläuterung der Erfindung wird nachfolgend auf die Zeichnung verwiesen. Deren einzige Figur zeigt als Ausführungsbeispiel eine prinzipielle Ausbildungsmöglichkeit eines Supraleiteraufbaus nach der Erfindung.

Bei der Gestaltung des Supraleiteraufbaus nach der Erfindung wird von an sich bekannten Ausführungsformen ausgegangen (vgl. die eingangs genannte Literaturstelle oder die genannte EP 0 292 959 A2). Der Supraleiteraufbau, der in der Figur allgemein mit 2 bezeichnet ist, umfaßt deshalb zumindest: Einen auch als Substrat zu bezeichnenden, langgestreckten Träger 3 mit einer Dicke d1. Auf dem Träger sind wenigstens zwei auch als Pufferschichten zu bezeichnende Zwischenschichten 4 bzw. 5 mit Dicken d2 bzw. d3 abgeschieden. Auf dem so gebildeten Zwischenschichtsvstem 6 ist eine Schicht 7 mit einer Dicke d4 aus einem speziellen HTS-Material aufgebracht. Für den Träger wird eine Platte oder ein Band oder eine sonstige langgestreckte Struktur aus einem metallischen Material mit einer an sich beliebigen Dicke d1 und den für den jeweiligen Anwendungsfall geforderten Abmessungen seiner Fläche verwendet. Der Träger kann dabei Teil eines Verbundkörpers mit mindestens noch einem weiteren, in der Figur nicht dargestellten Element sein. Dieses Element kann zur mechanischen Verstärkung und/oder zur elektrischen Stabilisierung vorgesehen werden und befindet sich beispielsweise auf der dem Zwischenschichtsystem 6 abgewandten Seite des Trägers. Ein solches weiteres Element kann beispielsweise aus Cu bestehen.

Als metallisches Material für den Träger 3 soll hier Nickel (Ni) oder eine Ni-Legierung gewählt sein. Beispielsweise sind spezielle Ni-Cu-Fe-Legierungen, insbesondere mit dem Handelsnamen "Monel", oder Ni-Legierungen mit mindestens einem der Legierungspartner V, Cr, Mo oder NiFe-Legierungen mit einem Fe-Anteil von maximal 80 Atom-% geeignet.

Um eine heteroepitaktische Abscheidung von rißfreien und gegen die Diffusion dichten Zwischenschichten auf dem Träger zu ermöglichen, soll zumindest seine dem Zwischenschichtsystem 6 zugewandte Oberfläche biaxial texturiert sein. Eine entsprechende Textur wird auch als "Würfellagentextur" bezeichnet. Sie läßt sich in an sich bekannter Weise durch einen Walzprozeß mit anschließender Rekristallisationsglühung erzeugen (vgl. die eingangs genannte Literaturstelle in "Applied Superconductivity"). Entsprechende bandförmige Substrate sind unter dem Handelsnamen "RABiTS" ("Rolling-Assisted Biaxially-Textured-Substrates) bekannt. Dabei muß über die gesamte (große) Länge des Trägers eine gleichbleibend hohe Texturgüte gewährleistet sein, was auch sehr wesentich mit der Korngröße zusammenhängt. Bei zu großen Körnern kann eine schlecht orientierte Korngrenze die Stromtragfähigkeit auf bis zu der gesamten Breite des Leiters beeinträchtigen.

Als HTS-Materialien kommen alle bekannten metalloxidischen Hoch-T_{c}-Supraleitermaterialien in Frage, die sich vom Typ (RE)₁M₂Cu₃Oₓ ableiten lassen. Dabei soll die RE(Rare Earth)-Komponente wenigstens ein Selten-Erd-Element (unter Einschluß von Y) wie z.B. Y enthalten. Bei der M-Komponente handelt es sich um wenigstens ein Erdalkalielement wie z.B. Ba. Hauptvertreter dieses Typs ist YBa₂Cu₃Oₓ (mit x = 7-δ, das sogenannte YBCO). Selbstverständlich kann mindestens eine der Komponenten dieses Materials durch ein anderes aus der jeweiligen Gruppe zumindest teilweise ersetzt sein.

Die Dicke d4 der HTS-Schicht ist an sich unkritisch und liegt im allgemeinen unter 2 µm.

Gegebenenfalls kann die HTS-Schicht 7 noch mit mindestens einer weiteren Schicht wie z.B. einer Schutzschicht oder einer Stabilisierungsschicht, insbesondere aus Ag oder einer Ag-Legierung, abgedeckt sein.

Um ein für eine hohe kritische Stromdichte J_{c} des HTS-Materials erforderliches texturiertes, insbesondere epitaktisches Wachstum zu ermöglichen, besteht die dem HTS-Material zugewandte Zwischenschicht 5 aus einem ein solches Wachstum gewährleistenden Material. Deshalb ist CeO₂ mit seiner an die kristallinen Abmessungen des HTS-Materials angepaßten Einheitszelle besonders geeignet. Die Kantenlänge der CeO₂-Einheitszelle beträgt 5,41 Å, so daß die Diagonale eine Länge von 7,65 Å hat. Dies ergibt eine Abweichung von 0,3 % bzw. 1,6 % von der doppelten Kantenlänge einer YBCO-Einheitszelle (a-Achse: 3,82 Å bzw. b-Achse: 3,89 Å).

Diese Schicht 5 mit einer Dicke d3, die vorteilhaft zwischen 10 nm und 200 nm liegt und vorzugsweise nicht 150 nm und insbesondere nicht 100 nm überschreitet, befindet sich auf der dem Träger 3 zugewandten Zwischenschicht 4. Für diese (untere) Zwischenschicht soll als Material Y₂O₃ mit einer vergleichsweise größeren Dicke gewählt werden. Die Dicke liegt dabei im allgemeinen zwischen 200 nm und 2 µm, beispielsweise bei etwa 1 µm. Entsprechende, 1 µm dicke, heteroepitaktisch auf dem Träger abgeschiedene Schichten weisen vorteilhaft keine Risse auf und haben zudem eine sogenannte In-plane-Textur mit einer Halbwertsbreite von etwa 8°. Direkt darauf abgeschiedenes YBCO zeigt jedoch noch unzureichende supraleitende Eigenschaften. Es wurde erkannt, daß sich diese Eigenschaften durch die weitere Zwischenschicht 5 aus CeO₂ deutlich verbessern lassen. Wird nämlich eine entsprechende Schicht 5 auf der Y₂O₃-Schicht 4 abgeschieden, so entsteht dann auf der CeO₂-Schicht orthorhombisches, biaxial texturiertes YBCO. Die Halbwertsbreite der Textur beträgt dabei etwa 11°, während die Sprungtemperatur T_{c} bei etwa 85 K mit einem ΔT_{c} von etwa 3 K liegt. Sowohl ein Theta-2-Theta-Scan als auch eine (111)-Polfigur der CeO₂-Schicht zeigen eine ausschließliche (100)-Orientierung der CeO₂-Körner sowie eine biaxiale Textur mit einer Halbwertsbreite von ca. 10°. Erst bei einer Schichtdicke deutlich über 100 nm treten wiederum Risse im CeO₂ auf.

Gegebenenfalls kann zwischen den beiden Zwischenschichten 4 und 5 noch eine weitere, dünne Schicht vorhanden sein, die ebenfalls aus oxidischem Material besteht und die erwünschte Heteroepitaxie nicht behindert. Ein entsprechendes Beispiel wäre eine 5 bis 20 nm dicke Schicht aus Al₂O₃, MgO, SrTiO₃ oder Zr(Y)O₂. Generell muß es eine diskrete Schicht mit gut definierter (angepaßter) Gitterkonstante sein, die eine Epitaxie ermöglicht.

Die Zwischenschichten 4 und 5 werden in an sich bekannter Weise auf dem Träger sukzessive abgeschieden. Hierzu sind alle gängigen Verfahren geeignet wie z.B. ein Sputtern, thermisches Verdampfen oder Laserablation. Die Abscheidung der Zwischenschichtmaterialien erfolgt dabei in den meisten Fällen bei erhöhten Temperaturen am Träger.

Auf dem Zwischenschichtsystem 6 wird anschließend das HTS-Material mit Hilfe bekannter Abscheideverfahren unter Aufheizung des Trägers aufgebracht. Die gängigsten der hierfür geeigneten Verfahren der PVD (Physical Vapor Deposition)-Technik sind die Laserablation unter Einsatz eines gepulsten Lasers, das Magnetron-Sputtern oder vorzugsweise ein thermisches Co-Verdampfen (= gleichzeitiges Verdampfen der Komponenten des HTS-Materials unter Sauerstoffzufuhr). Auch CVD (Chemical Vapor Deposition)-Verfahren, insbesondere unter Verwendung von metallorganischen Ausgangsmaterialien, sind geeignet. Die Verfahren sind dabei vorzugsweise so auszuwählen, daß eine heteroepitaktische Abscheidung gewährleistet ist.

Ein konkretes Ausführungsbeispiel eines erfindungsgemäßen,in der Figur angedeuteten Leiteraufbaus ist nachfolgend aufgeführt:

Auf der würfeltexturierten Oberfläche eines mindestens 10 cm langen bandförmigen Trägers 3 aus Ni₅₀Fe₅₀, dessen Dicke dl 0,1 mm und dessen Breite 10 mm betrugen, wurde bei 800°C mittels Laserablation zunächst eine erste Zwischenschicht 4 aus Y₂O₃ mit einer Dicke d2 von 0,9 µm und dann eine zweite Zwischenschicht 5 aus CeO₂ mit einer Dicke d3 von 0,1 µm abgeschieden. Auf dem so gebildeten Zwischenschichtsystem 6 wurde anschließend bei 780°C mittels Laserablation eine YBCO-Schicht 7 mit einer Dicke d4 von 0,5 µm aufgebracht. Dieser Leiteraufbau 2 wurde anschließend bei etwa 700°C in reinem Sauerstoff in der Beschichtungskammer etwa 30 Minuten lang geglüht und anschließend in der Kammer innerhalb von 20 Minuten auf Raumtemperatur abgekühlt. Die kritische Stromdichte J_{c} des so gewonnenen Leiteraufbaus betrug dann etwa 1 x 10⁵ A/cm².

Selbstverständlich ist es möglich, den vorstehend erläuterten Leiteraufbau nach der Erfindung noch mit mindestens einer seine HTS-Schicht elektrisch stabilisierenden Schicht oder mit einem entsprechenden Körper oder Element aus normalleitendem Material wie z.B. aus Ag oder einer Ag-Legierung zu versehen.

## Patentansprüche

1. Langgestreckter Supraleiteraufbau (2) zur Führung eines elektrischen Stromes in einer vorbestimmten Richtung-mit wenigstens folgenden Teilen, nämlich
- einem biaxial texturierten Träger (3) aus metallischem Material
- einem auf dem Träger abgeschiedenen Zwischenschichtsystem (6) mit mindestens zwei Zwischenschichten (4, 5) aus verschiedenen oxidischen Materialien
und
- einer auf dem Zwischenschichtsystem (6) abgeschiedenen Supraleitungsschicht (7) aus einem Hoch-T_{c}-Supraleitermaterial vom Typ (RE)M₂Cu₃Oₓ, wobei die Komponente RE wenigstens ein Seltenes Erdmetall (einschließlich Yttrium) und die Komponente M wenigstens ein Erdalkalimetall enthalten, **dadurch gekennzeichnet, daß** das Zwischenschichtsystem (6) eine dem Träger (3) zugewandte Zwischenschicht (4) aus einem Yttrium-Oxid und eine der Supraleitungsschicht (7) zugewandte, vergleichsweise dünnere Zwischenschicht (5) aus einem Cer-Oxid aufweist.

2. Supraleiteraufbau nach Anspruch 1, **dadurch gekennzeichnet, daß** das Supraleitermaterial vom Typ YBa₂Cu₃Oₓ ist.

3. Supraleiteraufbau nach Anspruch 2, **dadurch gekennzeichnet, daß** die Y-Komponente und/oder die Ba-Komponente zumindest teilweise durch ein Element aus der jeweils entsprechenden Gruppe ersetzt sind/ist.

4. Supraleiteraufbau nach einem der vorangehenden Ansprüche, **dadurch gekennzeichnet, daß** die insbesondere aus CeO₂ bestehende Cer-Oxid-Zwischenschicht eine Dicke (d3) von unter 200 nm, vorzugsweise unter 100 nm hat, und mindestens 10 nm dick ist.

5. Supraleiteraufbau nach einem der vorangehenden Ansprüche, **dadurch gekennzeichnet, daß** die insbesondere aus Y₂O₃ bestehende Yttrium-Oxid-Zwischenschicht (4) eine Dicke (d2) zwischen 200 nm und 2 µm hat.

6. Supraleiteraufbau nach einem der vorangehenden Ansprüche, **gekennzeichnet durch** eine Supraleitungsschicht (7) mit einer Dicke (D4) von höchstens 2 µm.

7. Supraleiteraufbau nach einem der vorangehenden Ansprüche, **gekennzeichnet durch** einen Träger (3) aus Nickel oder einer Nickel-Legierung.

8. Supraleiteraufbau nach einem der vorangehenden Ansprüche, **gekennzeichnet durch** einen Träger (3), der zumindest an seiner dem Zwischenschichtsystem (6) zugewandten Oberfläche eine Walztextur aufweist.

9. Supraleiteraufbau nach einem der vorangehenden Ansprüche, **gekennzeichnet durch** einen Träger (3) mit Bandform.

10. Supraleiteraufbau nach einem der vorangehenden Ansprüche, **gekennzeichnet durch** einen Träger (3), der Teil eines Verbundkörpers mit mindestens einem weiteren Element ist.

11. Supraleiteraufbau nach einem der vorangehenden Ansprüche, **dadurch gekennzeichnet, daß** der Supraleitungsschicht (7) zur elektrischen Stabilisierung normalleitendes Material, insbesondere aus Silber oder einer Silber-Legierung, zugeordnet ist.

12. Verfahren zur Herstellung eines Supraleiteraufbaus nach einem der vorangehenden Ansprüche, **gekennzeichnet durch** ein zumindest weitgehend heteroepitaktisches Wachstum der Zwischenschichten (4, 5) und der Supraleitungsschicht (7).

## Claims

1. Elongated superconductor structure (2) for carrying an electric current in a predetermined direction and having at least the following parts, namely,
- a biaxially textured mount (3) composed of metallic material,
- an intermediate layer system (6), which is deposited on the mount and has at least two intermediate layers (4, 5) composed of different oxidic materials,
and
- a superconductor layer (7) which is deposited on the intermediate layer system (6) and is composed of a high-T_{c} superconductor material of the (RE)M₂Cu₃Oₓ type, with the RE component containing at least one rare earth metal (including yttrium), and the M component containing at least one alkaline-earth metal, **characterized in that** the intermediate layer system (6) has an intermediate layer (4) which faces the mount (3) and is composed of an yttrium oxide, and a relatively thinner intermediate layer (5) which faces the superconductor layer (7) and is composed of cerium oxide.

2. Superconductor structure according to Claim 1, **characterized in that** the superconductor material is of the YBa₂Cu₃Oₓ type.

3. Superconductor structure according to Claim 2, **characterized in that** the Y component and/or the Ba component are/is at least partially replaced by an element from the respectively corresponding group.

4. Superconductor structure according to one of the preceding claims, **characterized in that** the cerium-oxide intermediate layer, which is composed in particular of CeO₂, has a thickness (d3) of less than 200 nm, preferably of less than 100 nm, and is at least 10 nm thick.

5. Superconductor structure according to one of the preceding claims, **characterized in that** the yttrium-oxide intermediate layer (4), which is composed in particular of Y₂O₃, has a thickness (d2) of between 200 nm and 2 µm.

6. Superconductor structure according to one of the preceding claims, **characterized by** a superconductor layer (7) having a thickness (D4) of at most 2 µm.

7. Superconductor structure according to one of the preceding claims, **characterized by** a mount (3) composed of nickel or a nickel alloy.

8. Superconductor structure according to one of the preceding claims, **characterized by** a mount (3) which has a rolled texture, at least on its surface facing the intermediate layer system (6).

9. Superconductor structure according to one of the preceding claims, **characterized by** a mount (3) in strip form.

10. Superconductor structure according to one of the preceding claims, **characterized by** a mount (3) which is part of a composite body having at least one further element.

11. Superconductor structure according to one of the preceding claims, **characterized in that** the superconductor layer (7) has associated normally conductive material, in particular composed of silver or a silver alloy, for electrical stabilization.

12. Method for producing a semiconductor structure according to one of the preceding claims, **characterized by** at least largely heteroepitaxial growth of the intermediate layers (4, 5) and of the superconducting layer (7).

## Revendications

1. Structure (2) supraconductrice s'étendant en longueur pour le passage d'un courant électrique dans un sens déterminé à l'avance comprenant au moins les parties suivantes, à savoir
- un support (3) texturé biaxialement en matériau métallique,
- un système (6) stratifié intermédiaire déposé sur le support et ayant au moins deux couches (4, 5) intermédiaires en des oxydes différents,
et
- une couche (7) supraconductrice déposée sur le système (6) stratifié intermédiaire en une matière supraconductrice à T_{c} haut du type (RE)M₂Cu₃Oₓ, les constituants RE contenant au moins un métal de terre rare (y compris l'yttrium) et les constituants M au moins un métal alcalino-terreux,
**caractérisée en ce que** le système (6) stratifié intermédiaire comporte une couche (4) intermédiaire qui est tournée vers le support (3) et qui est en oxyde d'yttrium et une couche (5) intermédiaire relativement mince qui est tournée vers la couche (7) supraconductrice et qui est en oxyde de cérium.

2. Structure supraconductrice suivant la revendication 1, **caractérisée en ce que** la matière supraconductrice est du type YBa₂Cu₃Oₓ.

3. Structure supraconductrice suivant la revendication 2, **caractérisée en ce que** les constituants Y et/ou les constituants au Ba est ou sont remplacés au moins en partie par un élément du groupe respectif correspondant.

4. Structure supraconductrice suivant l'une des revendications précédentes, **caractérisée en ce que** la couche intermédiaire en oxyde de cérium, notamment en CeO₂, a une épaisseur (d3) inférieure à 200 nm, de préférence inférieure à 100 nm, et a une épaisseur d'au moins 10 nm.

5. Structure supraconductrice suivant l'une des revendications précédentes, **caractérisée en ce que** la couche (4) intermédiaire en oxyde d'yttrium, notamment en Y₂O₃, a une épaisseur (d2) comprise entre 200 nm et 2 µm.

6. Structure supraconductrice suivant l'une des revendications précédentes, **caractérisée par** une couche (7) supraconductrice d'une épaisseur (D4) de 2 µm au plus.

7. Structure supraconductrice suivant l'une des revendications précédentes, **caractérisée par** un support (3) en nickel ou en un alliage de nickel.

8. Structure supraconductrice suivant l'une des revendications précédentes, **caractérisée par** un support (3) qui a une texture laminée au moins sur sa surface tournée vers le système (6) stratifié intermédiaire.

9. Structure supraconductrice suivant l'une des revendications précédentes, **caractérisée par** un support (3) ayant une forme en bande.

10. Structure supraconductrice suivant l'une des revendications précédentes, **caractérisée par** un support (3) qui fait partie d'un corps composite ayant au moins un autre élément.

11. Structure supraconductrice suivant l'une des revendications précédentes, **caractérisée en ce qu'**il est associé à la couche (7) supraconductrice, pour la stabilisation électrique, de la matière normalement conductrice, notamment en argent ou en alliage d'argent.

12. Procédé de production d'une structure supraconductrice suivant l'une des revendications précédentes, **caractérisé par** une croissance au moins dans une grande mesure hétéroépitactique des couches (4, 5) intermédiaires et de la couche (7) supraconductrice.
